# EUROPEAN PATENT APPLICATION

(11) **EP 3 419 068 A1**
(43) Date of publication of application: **26.12.2018**
(21) Application number: 17753328.8
(22) Date of filing: 17.02.2017
(51) Int. Cl.: H01L 51/44

(54) **SOLID JUNCTION-TYPE PHOTOELECTRIC TRANSDUCER AND METHOD FOR PRODUCING SAME**

(30) Priority: 19.02.2016 JP 2016029952
(71) Applicant: Sekisui Chemical Co., Ltd., Osaka-shi, Osaka 530-8565 (JP)
(72) Inventor: FUJINUMA, Naohiro, Tsukuba-shi Ibaraki 300-4292 (JP); ANZAI, Junichiro, Tsukuba-shi Ibaraki 300-4292 (JP)
(74) Representative: Müller-Boré & Partner Patentanwälte PartG mbB
(86) International application number: PCT/JP2017/005959
(87) International publication number: WO 2017/142074

(57) **Abstract**

A solid junction-type photovoltaic device including: a substrate; a first conductive layer; a power generation layer including a perovskite layer; and a conductive material including a second conductive layer, which are laminated in this order, wherein the conductive material has a self-supporting property.

## Description

### TECHNICAL FIELD

The present invention relates to a solid junction-type photovoltaic device, and a method for producing the same.

Priority is claimed on Japanese Patent Application No. 2016-029952, filed February 19, 2016, the content of which is incorporated herein by reference.

### BACKGROUND ART

In recent years, it was reported that a solid junction-type photovoltaic device including a power generation layer containing a perovskite compound exhibits high photoelectric conversion efficiency (Non-Patent Document 1), and such a solid junction-type photovoltaic device has been attracting attention as a new photovoltaic device. This report was followed by successive reports on further improvements in photoelectric conversion efficiency (for example, Non-Patent Document 2).

### Prior Art References

### Non-Patent Document

Non-Patent Document 1: "Efficient Hybrid Solar Cells Based on Meso-Superstructured Organometal Halide Perovskites" Science, 2012, 338, p643-647.
Non-Patent Document 2: "Solvent engineering for high-performance inorganic-organic hybrid perovskite solar cells" Nature Materials 2014, 13, p897-903.

### DISCLOSURE OF INVENTION

### Problems to be Solved by the Invention

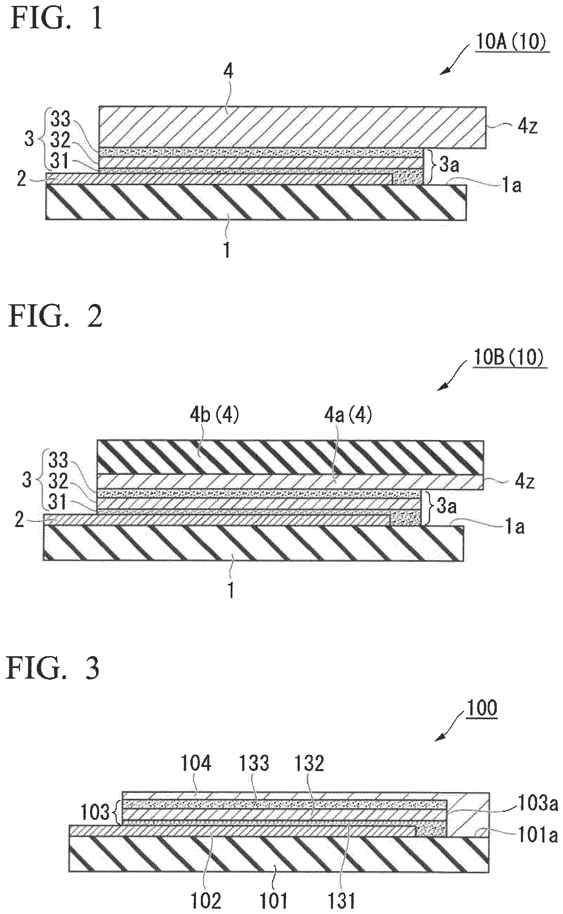

A cross-sectional view of a laminated structure of a conventional solid junction-type photovoltaic device is shown in FIG. 3. The general process for forming the laminated structure includes a series of film forming steps as follows. A first conductive layer 102 is formed on a substrate 101 by a physical vapor deposition method such as a sputtering method, and a power generation layer 103 including a perovskite layer is formed by a coating method such as a spin coating method, and a second conductive layer 104 is formed by a physical vapor deposition method, a printing method, or the like. In these film forming steps, when cracks penetrating in the thicknesswise direction of the power generation layer 103 occur during formation of the second conductive layer 104, a part of the second conductive layer 104 intrudes into cracks, thereby forming conductive protrusions extending toward the first conductive layer 102. When the tip of the conductive protrusion reaches the first conductive layer 102 or the N-type semiconductor layer 131, a problem arises that the second conductive layer 104 and the first conductive layer 102 are short-circuited to generate a leak current.

The present invention has been made in view of the above situation, and the object of the present invention is to provide a solid junction-type photovoltaic device which is unlikely to generate a leak current, and a method for producing the same.

### Means to Solve the Problems

[1] A solid junction-type photovoltaic device including: a substrate; a first conductive layer; a power generation layer including a perovskite layer; and a conductive material including a second conductive layer, which are laminated in this order, wherein the conductive material has a self-supporting property.
[2] The solid junction-type photovoltaic device according to [1], wherein the conductive material has a thickness of 1 µm or more.
[3] The solid junction-type photovoltaic device according to [1] or [2], wherein the second conductive layer is a metal foil.
[4] The solid junction-type photovoltaic device according to [1] or [2], wherein the conductive material is a laminate comprising the second conductive layer and a support.
[5] The solid junction-type photovoltaic device according to [4], wherein the second conductive layer comprises at least one member selected from the group consisting of a metal, a metal oxide, a carbon material, and an organic polymer material.
[6] The solid junction-type photovoltaic device according to any one of [1] to [5], wherein the power generation layer has at least one crack extending from its surface on a side of the conductive material toward the first conductive layer, and the conductive material adheres to the power generation layer and extends over the crack.
[7] A method for producing a solid junction-type photovoltaic device including: a first conductive layer; a power generation layer including a perovskite layer; and a conductive material comprising a second conductive layer, which are laminated in this order, the method including: a step of laminating, on a substrate, the first conductive layer and the power generation layer in this order; and a step of attaching the conductive material onto the power generation layer.
[8] The method according to [7], wherein, in the step of attaching the conductive material onto the power generation layer, the conductive material is placed on the power generation layer, followed by pressing to thereby attach the conductive material onto the power generation layer.
[9] The method according to [7] or [8], wherein the second conductive layer is a metal foil.
[10] The method according to [7] or [8], wherein the conductive material is a laminate comprising the second conductive layer and a support.
[11] The method according to [10], wherein the second conductive layer comprises at least one member selected from the group consisting of a metal, a metal oxide, a carbon material, and an organic polymer material.

### Effect of the Invention

The solid junction-type photovoltaic device of the present invention is unlikely to suffer from a leak current even when deflected or distorted by the application of external stress.

By the method of the present invention, a solid junction-type photovoltaic device unlikely to suffer from a leak current can be easily produced.

### BRIEF DESCRIPTION OF THE DRAWINGS

FIG. 1 is a cross-sectional view of the solid junction-type photovoltaic device according to a first embodiment of the present invention.
FIG. 2 is a cross-sectional view of the solid junction-type photovoltaic device according to a second embodiment of the present invention.
FIG. 3 is a cross-sectional view of a conventional solid junction-type photovoltaic device.

### DESCRIPTION OF THE EMBODIMENTS

Hereinbelow, the present invention is described based on the preferred embodiments thereof with reference to the drawings which, however, should not be construed as limiting the scope of the present invention.

In the present specification, the expressions "film" and "layer" are indiscriminately used unless otherwise specified. Further, the solid junction-type photovoltaic device may also be simply referred to as "photovoltaic device", and the organic-inorganic perovskite compound may also be simply referred to as "perovskite compound".

### «Solid Junction-type Photovoltaic device»

As shown in FIG. 1 and FIG. 2, the solid junction-type photovoltaic device of the present invention includes: a substrate 1; a first conductive layer 2; a power generation layer 3 including a perovskite layer 32; and a conductive material 4 including a second conductive layer, which are laminated in this order, wherein the conductive material 4 has a self-supporting property.

Here, "conductive material 4 has a self-supporting property" means that the conductive material 4 can be handled independently as a film (planar shaped member).

Whether or not the conductive material 4 has a self-supporting property can be determined by the following method. For example, a rectangular film (conductive material 4) having a size of 1 mm × 2 mm in a plan view is prepared, and a planar surface of the film is contacted with and fixed to the end of a horizontal platform over a half (1 mm × 1 mm) of the film as viewed in the longitudinal direction thereof, while allowing the remaining half of the film to project horizontally and outwardly from the end of the platform. The "end" of the platform is a side which is a straight line, to which the shorter side (the side of the tip) of the projecting film extends substantially in parallel. The resulting projecting portion of the film is visually observed to determine whether or not 90% or more of the total area of the projecting portion of the film as viewed in plan is maintained without falling away for at least 10 seconds.

When the conductive material has a self-supporting property, 90% or more of the total area of the projecting portion of the film is maintained for at least 10 seconds in the above test.

When the conductive material does not have a self-supporting property, more than 10% of the total area of the projecting portion of the film falls away under its own weight within 10 seconds in the above test.

As for the thickness of the conductive material 4, the thickness is preferably 1 µm or more, because such a thickness is advantageous for easily imparting the conductive material 4 with self-supporting property and for easily preventing a leakage current. The thickness is more preferably 2 µm or more.

Specifically, the thickness of the conductive material 4 is preferably 1 µm to 200 µm, and more preferably 2 µm to 100 µm. When the thickness is 200 µm or less, it is easy to reduce the thickness of the photovoltaic device.

The ratio of the thickness T (unit: µm) of the conductive material 4 to the area S (unit: cm²) of the conductive material 4 in plan view, i.e., S/T (unit: cm²/µm), is preferably 1 to 1000, more preferably from 1 to 500, and still more preferably from 1 to 100, because the conductive material 4 is allowed to have high self-supporting property, the handling of the conductive material 4 during the production of the solid junction-type photovoltaic device is easy, and the leak current can be easily prevented.

In the present specification, the thickness of each layer is determined as follows: the cross-section in the thickness-wise direction of the solid junction-type photovoltaic device is observed with an electron microscope to measure the thickness of a layer at arbitrarily chosen 10 places, and the arithmetic mean value of the thickness values is obtained as the thickness of the layer.

As shown in FIG. 1 and FIG. 2, since the conductive material 4 has a self-supporting property, the end portion 4z of the conductive material 4 that protrudes from the end portion of the power generation layer 3 hardly droops due to gravity, and does not contact the side surface 3a of the power generation layer 3.

On the other hand, in the conventional photovoltaic device 100 as shown in FIG. 3, the second conductive layer 104 is also formed on the side surface 103a of the power generation layer as well as on the front surface 101a of the substrate. This difference between the present invention and the conventional one is attributable to the difference in the manufacturing method.

Though not shown in FIG. 1 and FIG. 2, even when the power generation layer 3 has one or more cracks extending from its surface on a side of the second conductive layer toward the first conductive layer, the conductive material 4 adhering to the power generation layer extends over the crack(s). The phrase "extend over" here means that the conductive material 4 covers the opening of the crack without filling the interior of the crack.

As the depth of the crack increases, the risk of leak current increases. For example, it can be said that a substantial risk of leak current is caused by a crack reaching a depth of 30 % or more of the thickness (100 %) of the power generation layer 3 excluding the N-type semiconductor layer 31 (that is, the total thickness of the perovskite layer 32 and the P-type semiconductor layer 33). The depth of the crack can be determined by observing the cross section of the power generation layer 3 with an electron microscope.

### [First Embodiment]

As shown in FIG. 1, the solid junction-type photovoltaic device 10A (10) of the first embodiment of the present invention includes a metal foil constituting the conductive material 4 on the power generation layer 3. This metal foil is the second conductive layer and the conductive material 4 is composed of the second conductive layer.

The thickness of the metal foil is preferably 1 µm to 500 µm, more preferably 2 µm to 200 µm, and still more preferably 5 µm to 100 µm.

With the thickness being not less than the lower limit of the above range, even when cracks are formed in the power generation layer 3 due to stress applied to the photovoltaic device, it is unlikely that a part of the metal foil intrudes into the cracks, whereby a leak current can be prevented.

When the thickness is not more than the upper limit of the above range, it is possible to prevent the metal foil from cracking or peeling when stress is applied to the photovoltaic device.

The type of the metal foil is not particularly limited, and it is preferable to use, for example, at least one metal selected from the group consisting of gold, silver, copper, aluminum, tungsten, nickel and chromium.

The present embodiment is explained above taking as an example the case where the entire conductive material 4 is a metal foil, but the entire conductive material 4 may be made of a conductive polymer.

Examples of the conductive polymer include known conductive polymers such as polyacetylene, poly(p-phenylene), poly(p-phenylenevinylene), polypyrrole, polythiophene, polyethylenedioxythiophene (PEDOT), polythienylenevinylene, polyfluorene, polyaniline, polyacene, and graphene.

### [Second Embodiment]

As shown in FIG. 2, the solid junction-type photovoltaic device 10B (10) of the second embodiment of the present invention includes the conductive material 4 on the power generation layer 3.

The conductive material 4 is a laminate including the second conductive layer 4a and a support 4b.

The thickness of the laminate is preferably 1 µm to 500 µm, more preferably 2 µm to 200 µm, and still more preferably 5 µm to 100 µm.

With the thickness being not less than the lower limit of the above range, even when cracks are formed in the power generation layer 3 due to stress applied to the photovoltaic device, the second conductive layer 4a is sufficiently supported and it is unlikely that a part of the second conductive layer 4a intrudes into the cracks, whereby a leak current can be prevented.

When the thickness is not more than the upper limit of the above range, it is possible to prevent the second conductive layer 4a from cracking or peeling when stress is applied to the photovoltaic device.

The thickness of the second conductive layer 4a is not particularly limited, and is, for example, preferably 10 nm to less than 5 µm, more preferably 10 nm to 1 µm, and still more preferably 50 nm to 500 nm.

With the thickness being not less than the lower limit of the above range, even when cracks are formed in the power generation layer 3 due to stress applied to the photovoltaic device, it is unlikely that a part of the second conductive layer 4a intrudes into the cracks, whereby a leak current can be prevented. In addition, it is possible to prevent the resistance of the second conductive layer 4a from being excessively increased, whereby the internal resistance of the photovoltaic device can be decreased.

When the thickness is not more than the upper limit of the above range, it is possible to prevent the second conductive layer 4a from cracking or peeling when stress is applied to the photovoltaic device.

The material of the second conductive layer 4a is not particularly limited, and it is preferable to use, for example, at least one metal selected from the group consisting of gold, silver, copper, aluminum, tungsten, nickel and chromium.

Examples of the material of the second conductive layer 4a include a metal oxide, a carbon material such as graphite, and an organic polymer material such as a conductive polymer.

The second conductive layer 4a may be formed of one type of material or two or more types of materials.

As to the shape of the support 4b, a flat plate or a film is preferable.

As to the thickness of the support 4b, the total thickness of the support and the second conductive layer 4a is preferably 5 µm or more. Specifically, for example, the thickness of the support 4 b is preferably 1 µm to 500 µm, more preferably 2 µm to 200 µm, and still more preferably 5 µm to 100 µm.

When the thickness is not less than the lower limit of the above range, the second conductive layer 4a can be more stably supported.

When the thickness is not more than the upper limit of the above range, it is advantageous for imparting flexibility to the photovoltaic device on the whole.

The support 4b is preferably transparent. The material of the support 4b may be an insulating material or a conductive material, but is preferably an insulating material. The conductivity of the conductive material 4 can be secured by the second conductive layer 4a. A suitable material for the support 4b is the same as a suitable material for the substrate 1 to be described later.

Hereinbelow, the other components will be described.

### <Substrate 1>

The type of the substrate 1 is not particularly limited, and for example, transparent substrates used for photoelectrodes of conventional photovoltaic cells can be mentioned. Examples of the transparent substrate include substrates made of glass or synthetic resins, and flexible films made of synthetic resins.

When the material of the transparent substrate is a synthetic resin, examples of the synthetic resin include a polyacrylic resin, a polycarbonate resin, a polyester resin, a polyimide resin, a polystyrene resin, a polyvinyl chloride resin, and a polyamide resin. Among these, a polyester resin, particularly polyethylene naphthalate (PEN) or polyethylene terephthalate (PET), is preferable from the viewpoint of producing a thin, light and flexible photovoltaic cell.

The combination of the thickness and material of the substrate 1 is not particularly limited, and, for example, the substrate 1 may be a glass substrate having a thickness of 1 mm to 10 mm, a resin film having a thickness of 0.01 mm to 3 mm, or the like.

### <First Conductive Layer 2>

The material of the first conductive layer 2 is not particularly limited, and it is preferable to use, for example, at least one metal selected from the group consisting of gold, silver, copper, aluminum, tungsten, nickel and chromium.

The thickness of the first conductive layer 2 is not particularly limited, and is preferably, for example, 10 nm to 100 nm.

### <Power Generation Layer 3>

In the power generation layer 3, an optional N-type semiconductor layer (block layer) 31, a perovskite layer (light absorption layer) 32 and an optional P-type semiconductor layer 33 are laminated in this order on the first conductive layer 2.

The N-type semiconductor layer 31 is not essential, but it is preferable that the N-type semiconductor layer 31 is disposed between the first conductive layer 2 and the perovskite layer 32.

The P-type semiconductor layer 33 is not essential, but it is preferable that the P-type semiconductor layer 33 is disposed between the conductive material 4 and the perovskite layer 32.

When at least one of the N-type semiconductor layer 31 and the P-type semiconductor layer 33 is disposed, loss of electromotive force is prevented and the photoelectric conversion efficiency is improved.

For obtaining the above effects, the N-type semiconductor layer 31 and the P-type semiconductor layer 33 are preferably nonporous dense layers.

As long as the mutual positional relationship between the layers constituting the power generation layer 3 is maintained, other layers may be inserted above or below any one of the layers of the power generation layer 3 on the premise that insertion of such other layers would not deviate from the gist of the present invention. For reducing the internal resistance of the photovoltaic device and enhancing the photoelectric conversion efficiency, it is preferable that the P-type semiconductor layer 33 is formed on the surface of the perovskite layer 32 and the conductive material 4 is formed on the surface of the P-type semiconductor layer 33.

### <N-type semiconductor layer 31>

The N-type semiconductor constituting the N-type semiconductor layer 31 is not particularly limited, and examples thereof include oxide semiconductors having excellent electron conductivity, such as ZnO, TiO₂, SnO, IGZO, and SrTiO₃. In particular, TiO₂ is preferable because of its excellent electron conductivity.

The N-type semiconductor layer 31 may be formed of one type of the N-type semiconductor or two or more types of N-type semiconductors.

The number of layers of the N-type semiconductor layer 31 may be one or two or more.

The total thickness of the N-type semiconductor layer 31 is not particularly limited, and may be, for example, about 1 nm to 1 µm. When the thickness is 1 nm or more, the above loss can be sufficiently prevented, and when the thickness is 1 µm or less, the internal resistance can be suppressed low.

### <Perovskite Layer 32>

The perovskite layer 32 is a layer containing a perovskite compound and may be formed only of a perovskite compound or may include a base layer (not shown) as a part or the whole of the layer. The base layer is a layer structurally supporting the perovskite layer 32.

The thickness of the perovskite layer 32 is not particularly limited, and is, for example, preferably 10 nm to 10 µm, more preferably 50 nm to 1 µm, and still more preferably 100 nm to 0.5 µm.

When the thickness is not less than the lower limit of the above range, the light absorption efficiency in the perovskite layer 32 is enhanced, leading to higher photoelectric conversion efficiency.

When the thickness is not more than the upper limit of the above range, the efficiency of photoelectrons generated in the perovskite layer 32 to reach the first conductive layer 2 is increased, leading to more excellent photoelectric conversion efficiency.

The thickness of the base layer which may be included in the perovskite layer 32 is not particularly limited, and is, for example, preferably 20 to 100 %, more preferably 30 to 80 %, with respect to the total thickness of the perovskite layer 32. Here, the thickness of the base layer is the thickness from the surface of the N-type semiconductor layer 31.

The type of the perovskite compound is not particularly limited, and a perovskite compound used in a known photovoltaic cell can be used. Specifically, the perovskite compound preferably has a crystal structure and exhibits light absorption by band gap excitation as in the case of a typical compound semiconductor. For example, the known perovskite compound CH₃NH₃PbI₃ is known to have an extinction coefficient per unit thickness (cm⁻¹) that is one digit higher than that of the sensitizing dye of the dye-sensitized photovoltaic cells.

The material of the base layer is preferably an N-type semiconductor and/or an insulator.

The base layer may be a porous film or a nonporous dense film, and is preferably a porous film. It is preferable that the perovskite compound is supported by the porous structure of the base layer. Even when the base layer is a dense film, it is preferable that the perovskite compound is contained in the dense film. It is preferable that the dense film is formed of an N-type semiconductor.

The type of the N-type semiconductor that can constitute the base layer is not particularly limited, and a known N-type semiconductor can be used. For example, oxide semiconductors used for forming photoelectrodes of the conventional dye-sensitized photovoltaic cells can be used. Specific examples of the oxide semiconductors include titanium oxide (TiO₂), zinc oxide (ZnO), tin oxide (SnO, SnO₂), IGZO, and strontium titanate (SrTiO₃). Alternatively, compound semiconductors containing Si, Cd or ZnS, which are doped with pentavalent elements, may also be used. Of these, titanium oxide is particularly preferable because of its excellent electron conductivity.

The N-type semiconductor constituting the base layer may be of one type or of two or more types.

The type of the insulator that can constitute the base layer is not particularly limited, and a known insulator can be used. For example, oxides used for forming insulating layers of the conventional semiconductor devices can be used. Specific examples of the oxides include zirconium dioxide, silicon dioxide, aluminum oxide (AlO, Al₂O₃), magnesium oxide (MgO), and nickel oxide (NiO). Of these, aluminum oxide (III) (Al₂O₃) is particularly preferable.

The insulator constituting the base layer may be of one type or of two or more types.

### <P-Type Semiconductor Layer 33>

The P-type semiconductor layer 33 formed on the surface of the perovskite layer 32 is made of a P-type semiconductor. When the P-type semiconductor layer 33 having holes is disposed between the perovskite layer 32 and the conductive material 4, the occurrence of reverse current can be suppressed, and electrons can move from the conductive material 4 to the perovskite layer 32 more efficiently. As a result, the photoelectric conversion efficiency and the voltage can be increased.

The type of the P-type semiconductor is not particularly limited, and may be an organic material or an inorganic material. For example, P-type semiconductors used in hole transport layers of known photovoltaic cells can be used. Examples of the organic material include 2,2', 7,7'-tetrakis(N,N-di-p-methoxyphenilamine) -9,9'-spirobifluorene (abbreviated as spiro-OMeTAD), poly(3-hexylthiophene) (abbreviated as P3HT), and polytriarylamine (abbreviated as PTAA).

Examples of the inorganic material include copper compounds such as CuI, CuSCN, CuO, Cu₂O and nickel compounds such as NiO.

The thickness of the P-type semiconductor layer 33 is not particularly limited, and is preferably 1 nm to 1000 nm, more preferably 5 nm to 500 nm, and still more preferably 30 nm to 500 nm.

When the thickness is not less than the lower limit of the above range, a high electromotive force can be attained.

When the thickness is not more than the upper limit of the above range, the internal resistance can be further reduced.

### «Power Generation by Solid Junction-type Photovoltaic device 10»

When the perovskite layer 32 absorbs light, photoelectrons and holes are generated in the layer. The photoelectrons are received by the N-type semiconductor layer 31 and move to a working electrode (positive electrode) constituted by the first conductive layer 2. On the other hand, the holes move to the counter electrode (negative electrode) constituted by the conductive material 4 via the P-type semiconductor layer 33.

The current generated by the photovoltaic device 10 can be taken out to the external circuit via the extraction electrode connected to the first conductive layer 2 and the conductive material 4.

### <<Method for Producing Solid Junction-Type Photovoltaic device>>

The method of the present invention for producing a solid junction-type photovoltaic device includes a step of forming, on a substrate 1, a first conductive layer 2 and a power generation layer 3 in this order, and a step of attaching a conductive material 4 including a second conductive layer onto the power generation layer 3.

As a method of attaching the conductive material 4 onto the power generation layer 3, for example, a method of pressing the conductive material 4 placed on the power generation layer 3 is preferable. Heating may be performed simultaneously with the pressing.

The area of the conductive material 4 to be attached as viewed in plan is preferably larger than the area of the power generation layer 3 as viewed in plan. With such an area, it is easy to attach the conductive material 4 without leaving uncovered portions in the power generation layer 3.

Hereinbelow, each step of the method will be described in detail.

### <Preparation of Substrate 1>

The substrate 1 can be produced by a conventional method, and a commercially available product may be used.

<Formation of First Conductive Layer 2>

The method of forming the first conductive layer 2 on the surface of the substrate 1 is not particularly limited, and a known film formation method such as a sputtering method, a vapor deposition method, or the like can be employed.

### <Formation ofN-type Semiconductor Layer 31>

An N-type semiconductor layer 31 is formed on the first conductive layer 2. The method of forming the N-type semiconductor layer 31 is not particularly limited, and a known method capable of forming a dense layer made of an N-type semiconductor with a desired thickness can be employed. Examples of such method include a sputtering method, a vapor deposition method, and sol-gel method in which a dispersion containing a precursor of an N-type semiconductor is applied to a substrate.

Examples of the precursor of the N type semiconductor include metal alkoxides, such as titanium tetrachloride (TiCl₄), peroxotitanic acid (PTA), and titanium alkoxides (such as titanium ethoxide, and titanium isopropoxide (TTIP)), zinc alkoxides, alkoxysilanes, and zirconium alkoxides.

### <Formation of Perovskite Layer 32>

In the case of forming the base layer supporting the perovskite layer 32, the method therefor is not particularly limited and, for example, a method used for forming a semiconductor layer carrying a sensitizing dye of a conventional dye-sensitized photovoltaic cell can be applied. Specifically, for example, a paste containing fine particles of an N-type semiconductor or an insulator and a binder is applied to the surface of the N-type semiconductor layer 31 by a doctor blade method, followed by drying and baking to form a porous base layer composed of fine particles. Alternatively, by spraying the fine particles onto the surface of the N-type semiconductor layer 31, it is possible to form a porous or non-porous base layer composed of the fine particles.

The method of spraying the fine particles is not particularly limited, and known methods can be employed. Examples of such methods include an aerosol deposition method (AD method), an electrostatic particle coating method (electrostatic spray method) where fine particles are accelerated by electrostatic force, and a cold spray method. Among these methods, the AD method is preferable because it is easy to adjust the speed of the sprayed fine particles, the film quality and thickness of the base layer to be formed can be easily controlled, and the film formation can be performed at low temperatures.

The method for allowing the perovskite compound to be contained in the base layer is not particularly limited, and examples thereof include a method of impregnating the formed base layer with a solution containing a perovskite compound or a precursor thereof, and a method of using a material to which a perovskite compound has been attached in advance to form the base layer. The above two methods may be used in combination.

The perovskite compound can be attached to the fine particles by, for example, a method in which the fine particles are immersed in a raw material solution in which a perovskite compound or a precursor of the perovskite compound is dissolved, followed by drying to remove the solvent, thereby obtaining raw material particles having a crystallized perovskite compound attached thereto.

A layer (upper layer) containing a perovskite compound may further be formed on the surface of the base layer. The method of forming the upper layer is not particularly limited, and examples thereof include the following method. That is, a raw material solution in which a perovskite compound or a precursor of a perovskite compound is dissolved is applied to the surface of the base layer to allow the raw material solution to permeate into the base layer and to form the raw material solution layer with a desired thickness on the surface of the base layer, followed by drying off the solvent.

At least a part of the raw material solution applied to the base layer permeates into the porous film of the base layer, and crystallization proceeds as the solvent is dried such that the perovskite compound adheres to and deposits in the inside of the porous film. Further, by applying a sufficient amount of the raw material solution, the raw material solution not having penetrated into the porous film forms the upper layer composed of the perovskite compound on the surface of the base layer as the solvent is dried off. The perovskite compound constituting the upper layer and the perovskite compound inside the base layer are integrally formed, meaning that a continuous perovskite layer 32 is formed.

The perovskite compound used in the present embodiment is not particularly limited as long as it can generate an electromotive force by light absorption, and a known perovskite compound can be used. Particularly preferred is a perovskite compound represented by the following composition formula (1), which can form a perovskite type crystal and has an organic component and an inorganic component within a single compound:

ABX₃ (1)

In the formula (1), A represents an organic cation, B represents a metal cation, and X represents a halide ion. In the perovskite crystal structure, the B sites can take an octahedral configuration in cooperation with the X sites. It is considered that mixing of atomic orbitals occurs between the metal cations of the B sites and the halide ions of the X sites so as to form a valence band and a conduction band related to photoelectric conversion.

The metal (cations) represented by B in the composition formula (1) is not particularly limited, and examples thereof include Cu, Ni, Mn, Fe, Co, Pd, Ge, Sn, Pb, and Eu. Among these, Pb and Sn are preferable, which can easily form a band with high conductivity by atomic orbital mixing with the halide ions at the X sites.

The metal cations at the B sites may be of one species or of two or more species.

The halogen (halide ions) represented by X in the composition formula (1) is not particularly limited, and examples thereof include F, Cl, Br, and I. Among these, Cl, Br and I are preferable, which can easily form a band with high conductivity by atomic orbital mixing with the metal cations at the B sites.

The halide ions at the X sites may be of one species or of two or more species.

The organic group (organic cation) represented by A in the composition formula (1) is not particularly limited, and examples thereof include an alkylammonium derivative and a formamidinium derivative.

The organic cations at the A site may be of one species or of two or more species.

Examples of the alkylammonium derivative as the organic cation include primary or secondary ammonium having an alkyl group having 1 to 6 carbon atoms, such as methylammonium, dimethylammonium, trimethylammonium, ethylammonium, propylammonium, isopropylammonium, tert-butylammonium, pentylammonium, hexylammonium, octylammonium, and phenyl ammonium. Among these, methylammonium is preferred since perovskite crystals can be easily obtained.

Examples of the formamidinium derivative as the organic cation include formamidinium, methylformamidinium, dimethylformamidinium, trimethylformamidinium, and tetramethylformamidinium. Among these, formamidinium is preferable since perovskite crystals can be easily obtained.

Suitable examples of the perovskite compound represented by the composition formula (1) include alkylammonium lead halides represented by the following composition formula (2): RNH₃PbX₃ (2). Specific examples of the alkylammonium lead halides represented by the composition formula (2) include CH₃NH₃PbI₃, CH₃NH₃PbI₃₋ₕClₕ (h is 0 to 3), and CH₃NH₃PbI₃₋ⱼBrⱼ (j is 0 to 3).

In the composition formula (2), R represents an alkyl group, and X represents a halide ion. The perovskite compound of this composition formula has a wide absorption wavelength range and, hence, can absorb sunlight over a wide wavelength range, so that excellent photoelectric conversion efficiency can be attained.

The alkyl group represented by R in the composition formula (2) is preferably a linear, branched or cyclic and saturated or unsaturated alkyl group having 1 to 6 carbon atoms, more preferably a linear saturated alkyl group having 1 to 6 carbon atoms, and still more preferably a methyl group, an ethyl group or an n-propyl group. With these suitable alkyl groups, perovskite crystals can be easily obtained.

Examples of the precursor contained in the raw material solution for the formation of the perovskite layer 32 include a halide (BX) containing metal ions for the aforementioned B sites and halide ions for the aforementioned X sites; and a halide (AX) containing organic cations for the aforementioned A sites and halide ions for the X sites.

A single raw material solution containing the halide (AX) and the halide (BX) may be applied to the base layer, or two raw material solutions respectively containing the halides may be sequentially applied to the base layer.

The solvent for the raw material solution is not particularly limited as long as the solvent dissolves the raw material and does not damage the base layer. Examples of the solvent include esters, ketones, ethers, alcohols, glycol ethers, amides, nitriles, carbonates, halogenated hydrocarbons, hydrocarbons, sulfones, sulfoxides, and formamide.

For example, the perovskite crystals of the perovskite compound represented by the composition formula (2) can be obtained by dissolving an alkylamine halide and a lead halide in a mixed solvent of γ-butyrolactone (GBL) and dimethyl sulfoxide (DMSO), followed by applying the solution to the base layer and drying. Furthermore, as described in Non-Patent Document 2, the production process for the perovskite compound may include an additional treatment wherein the perovskite crystals are coated with a solvent that does not dissolve the perovskite crystals and is miscible with GBL or DMSO, such as toluene or chloroform, followed by heating at about 100 °C, thereby annealing the perovskite crystals. This additional treatment may improve the stability of the perovskite crystals to increase the photoelectric conversion efficiency.

The concentration of the raw material in the raw material solution is not particularly limited, but is preferably such that the raw material is sufficiently dissolved and the raw material solution has such a viscosity that allows the raw material solution to permeate into the porous film.

The amount of the raw material solution to be applied to the base layer is not particularly limited, but is preferably, for example, such that the raw material solution permeates into the whole or at least a part of the inside of the porous film and that an upper layer is formed on the surface of the porous film so as to have a thickness of about 1 nm to 1 µm.

The method of applying the raw material solution to the base layer is not particularly limited, and known methods such as a gravure coating method, a bar coating method, a printing method, a spraying method, a spin coating method, a dipping method and a die coating method can be employed.

The method of drying the raw material solution applied to the base layer is not particularly limited, and known methods such as natural drying, reduced pressure drying and hot air drying can be employed.

The drying temperature of the raw material solution applied to the base layer is not particularly limited as long as the crystallization of the perovskite compound sufficiently proceeds, and is, for example, in the range of 40 to 150 °C.

### <Formation of P-type Semiconductor Layer 33>

The method of forming the P-type semiconductor layer 33 is not particularly limited. For example, the P-type semiconductor layer 33 can be formed by a method in which a P-type semiconductor is dissolved or dispersed in a solvent which is a poor solvent to the perovskite compound constituting the perovskite layer 32, and the resultant is applied to the surface of the perovskite layer 32, followed by drying.

Through the steps as described above, the power generation layer 3 including the N-type semiconductor layer 31, the perovskite layer 32 and the P-type semiconductor layer 33 which are laminated in this order can be formed.

### Examples

### [Example 1]

A transparent resin substrate (PEN substrate) having a transparent conductive layer made of ITO formed on the surface was prepared. A part of this ITO layer was etched with hydrochloric acid. The purpose of this etching was to leave only the region for forming the power generation layer and the region required for the lead-out wiring out of the ITO layer formed on the entire surface of the PEN substrate, while removing other unnecessary regions.

Subsequently, a DMF solution in which 1 M of CH₃NH₃PbI₃ was dissolved was spin-coated on the PEN substrate, followed by drying at 100 °C for 90 minutes to form a perovskite layer (power generation layer).

Thereafter, a self-supporting gold foil (Au foil) having a thickness of 10 µm was placed on the perovskite layer, and the gold foil and the PEN substrate were clamped with clips to press-bond the gold foil to the power generation layer.

20 of the thus produced solid junction photovoltaic devices were tested to determine the incidence of leak current (i.e., leak incidence) by a method described below. As a result, 16 passed the test and 4 failed. That is, the leak current occurred in 4 out of the 20 of the produced solid junction-type photovoltaic devices; therefore, the leak incidence was 20 %.

In order to evaluate the leak incidence of the photovoltaic devices, the current-voltage characteristic in the dark was measured with a source meter. Specifically, the current-voltage characteristic was evaluated by measuring parallel resistance Rsh. In this evaluation, Rsh in the dark was defined as "(gradient of current with respect to voltage) = (voltage variation) / (current variation)" around 0 V. According to this definition, a smaller Rsh means a higher likelihood of flow of leak current. Therefore, the photovoltaic devices having an Rsh of 1000 or less were evaluated as defective products having experienced occurrence of leak current.

### [Examples 2 to 5]

Photovoltaic devices were produced and evaluated in the same manner as in Example 1 except that self-supporting Ti foil, Al foil and Ag foil, each having a thickness of 50 µm, were used instead of the Au foil. The results are shown in Table 1.

### [Examples 6 to 9]

Photovoltaic devices were produced and evaluated in the same manner as in Example 1, except that self-supporting conductive materials having 0.1 µm-thick Au layer, Ti layer, Al layer and Ag layer formed on 125 µm-thick PEN films were respectively used instead of the Au foil. The results are shown in Table 1.

### [Comparative Examples 1 to 4]

Instead of the method used in the Examples where the conductive material was placed on the power generation layer, a physical vapor deposition method was employed so as to form second conductive layers of 100 nm-thick Au film, Ti film, Al film and Ag film on the power generation layers, thereby producing solid junction-type photovoltaic devices of the Comparative Examples. When handled independently, none of the 100 nm-thick metal films used to form the second conductive layers have self-supporting property in the above evaluation.

With respect to the produced solid junction-type photovoltaic devices of the Comparative Examples, the leak incidence was examined by the same method as in the Examples. The results are shown in Table 1.

**[Table 1]**

| | Conductive Material | | Conductive Layer Fonning Method | Leak Incidence (%) |
|---|---|---|---|---|
| | Conductive Layer | Support | | |
| Ex. 1 | Au foil(50µm) | None | Pressing after placing conductive material | 20 |
| Ex. 2 | Ti foil(50µm) | None | Pressing after placing conductive material | 10 |
| Ex. 3 | Al foil(50µm) | None | Pressing after placing conductive material | 15 |
| Ex. 5 | Ag foil(50µm) | None | Pressing after placing conductive material | 10 |
| Ex. 6 | Au | PEN(125µm) | Pressing after placing conductive material | 5 |
| Ex. 7 | Ti | PEN(125µm) | Pressing after placing conductive material | 10 |
| Ex. 8 | Al | PEN(125µm) | Pressing after placing conductive material | 5 |
| Ex. 9 | Ag | PEN(125µm) | Pressing after placing conductive material | 10 |
| Comp.Ex. 1 | Au (100nm) | None | Physical vapor deposition | 65 |
| Comp.Ex. 2 | Ti (100nm) | None | Physical vapor deposition | 80 |
| Comp.Ex. 3 | Al (100nm) | None | Physical vapor deposition | 50 |
| Comp.Ex. 4 | Ag (100nm) | None | Physical vapor deposition | 60 |

From the above results, it is apparent that the solid junction-type photovoltaic devices according to the present invention are not likely to suffer from a leak current, and can be produced with good yield.

The specific reason for the leak current occurred in some of the Examples has not been elucidated; however, the roughness of the ITO film formed on the PEN substrate or the press (press-bonding) condition is presumed to be one of the causes.

The elements, combinations thereof, etc. that are explained above in connection with the specific embodiments of the present invention are mere examples, and various alterations such as addition, omission and substitution of any components, etc. may be made as long as such alterations do not deviate from the gist of the present invention. Further, the present invention is in no way limited by these embodiments.

### INDUSTRIAL APPLICABILITY

The solid junction-type photovoltaic device of the present invention is unlikely to suffer from a leak current even when deflected or distorted by the application of external stress.

By the method of the present invention, a solid junction-type photovoltaic device unlikely to suffer from a leak current can be easily produced.

### DESCRIPTION OF THE REFERENCE SIGNS

- 1: Substrate
- 2: First Conductive Layer
- 3: Power Generation Layer
- 3a: Side of Power Generation Layer
- 4: Conductive Material
- 4a: Second Conductive Layer
- 4b: Support
- 10: Solid Junction-type Photovoltaic device
- 31: N-type Semiconductor Layer
- 32: Perovskite Layer
- 33: P-type Semiconductor Layer
- 100: Comparative Solid Junction-type Photovoltaic device
- 101: Substrate
- 101a: Surface of Substrate
- 102: First Conductive Layer
- 103: Power Generation Layer
- 103a: Side of Power Generation Layer
- 104: Second Conductive Layer
- 131: N-type Semiconductor Layer
- 132: Perovskite Layer
- 133: P-type Semiconductor Layer

## Claims

1. A solid junction-type photovoltaic device comprising: a substrate; a first conductive layer; a power generation layer comprising a perovskite layer; and a conductive material comprising a second conductive layer, which are laminated in this order,
wherein the conductive material has a self-supporting property.

2. The solid junction-type photovoltaic device according to claim 1, wherein the conductive material has a thickness of 1 µm or more.

3. The solid junction-type photovoltaic device according to claim 1 or 2, wherein the second conductive layer is a metal foil.

4. The solid junction-type photovoltaic device according to claim 1 or 2, wherein the conductive material is a laminate comprising the second conductive layer and a support.

5. The solid junction type photovoltaic device according to claim 4, wherein the second conductive layer comprises at least one member selected from the group consisting of a metal, a metal oxide, a carbon material, and an organic polymer material.

6. The solid junction-type photovoltaic device according to any one of claims 1 to 5, wherein the power generation layer has at least one crack extending from its surface on a side of the conductive material toward the first conductive layer, and
the conductive material adheres to the power generation layer and extends over the crack.

7. A method for producing a solid junction-type photovoltaic device comprising: a first conductive layer; a power generation layer comprising a perovskite layer; and a conductive material comprising a second conductive layer, which are laminated in this order, the method comprising:
a step of forming, on a substrate, the first conductive layer and the power generation layer in this order; and
a step of attaching the conductive material onto the power generation layer.

8. The method according to claim 7, wherein, in the step of attaching the conductive material onto the power generation layer, the conductive material is placed on the power generation layer, followed by pressing to thereby attach the conductive material onto the power generation layer.

9. The method according to claim 7 or 8, wherein the second conductive layer is a metal foil.

10. The method according to claim 7 or 8, wherein the conductive material is a laminate comprising the second conductive layer and a support.

11. The method according to claim 10, wherein the second conductive layer comprises at least one member selected from the group consisting of a metal, a metal oxide, a carbon material, and an organic polymer material.
